# EUROPEAN PATENT APPLICATION

(11) **EP 3 967 166 A1**
(43) Date of publication of application: **16.03.2022**
(21) Application number: 20879559.1
(22) Date of filing: 23.10.2020
(51) Int. Cl.: A24F 47/00

(54) **HEATING ELEMENT AND PREPARATION METHOD AND USE THEREFOR**

(30) Priority: 23.10.2019 CN 201911012121
(71) Applicant: China Tobacco Hubei Industrial Corporation Limited, Dongxihu District Wuhan Hubei 430040 (CN)
(72) Inventor: LIU, Huachen, Wuhan, Hubei 430040 (CN); LI, Dan, Wuhan, Hubei 430040 (CN); CHEN, Yikun, Wuhan, Hubei 430040 (CN); LIU, Lei, District Hubei 430040 (CN); LIU, Bing, Wuhan, Hubei 430040 (CN)
(74) Representative: Sarpi, Maurizio
(86) International application number: PCT/CN2020/123175
(87) International publication number: WO 2021/078248

(57) **Abstract**

A heating element and a preparation method and a use therefor is provided. The heating element including substrate and a coating covering an outer surface of the substrate; wherein the substrate includes a hard phase and a continuous phase; the hard phase includes a single-phase ceramic or a multi-phase ceramic, the continuous phase includes a single metal or alloy; the coating is configured to prevent the heating element from oxidizing. The method for preparing the heating element includes the following steps: (1) obtaining single-phase or multi-phase ceramic powder, and single metal or alloy powder; (2) obtaining a powder slurry by ball milling the single-phase or multi-phase ceramic powder, the single metal or alloy powder and additive powder; (3) obtaining granulated powder by drying the powder slurry; (4) obtaining the substrate by compression molding and sintering the granulated powder; (5) obtaining the heating element by coating a surface the substrate. A use of the heating element in a heater for new tobacco products is also provided. The heating element features good anti-oxidation performance, stable quality, and good heating uniformity. The preparation process is simple and efficient, and is economical.

## Description

### TECHNICAL FIELD

The present disclosure relates to a heating element and a method for preparing the same and a use thereof, belonging to the technical field of composite materials and powder metallurgy.

### BACKGROUND

The functional principle of low-temperature cigarettes is: through the heating element material under certain external field conditions, the temperature is quickly raised to the target temperature (generally 300-400°C (Degrees Celsius)), and then the surrounding special tobacco are baked to produce smoking effect similar to traditional cigarettes. Because the smoking temperature of low-temperature cigarettes is lower, the toxicity is lower than traditional cigarettes, and special flavors can be added or the taste can be optimized according to different needs, such that they are greatly welcomed around the world.

At present, the heating method used in low-temperature cigarettes is usually resistance heating, and the heat source is generated by the way of current passing through the heating resistor. The heating element in the related equipment is generally MCH ceramic (ceramic heating element). The ceramic heating element usually prints the heating slurry on the ceramic blank according to a certain circuit, realizes the metallurgical bonding through the subsequent firing process, and then encapsulates the glaze to connect the electrodes. However, although the ceramic heating element can meet the product demand to a certain extent, its preparation process is complicated, the cost is high, and there are problems of uneven product quality. These shortcomings will seriously hinder the market application of low-temperature cigarettes.

Therefore, there is an urgent need to develop new heating materials. The performance requirements of the heating element for low-temperature cigarettes are mainly: 1) bio-compatibility, non-toxic under low and high temperature conditions; 2) adjustable resistance; 3) able to withstand a certain degree of high temperature, good oxidation resistance and high temperature stability, and with a certain high temperature resistance; 4) can withstand the corrosion of tobacco media, with good chemical stability; 5) good thermal conductivity; 6) good room temperature and high temperature mechanical properties; 7) the service life is more than tens of thousands of times. The existing single alloy or ceramic material can hardly meet the above requirements.

### SUMMARY

In view of the above problems, the present disclosure is intended to provide a heating element and its preparation method and use, such that it can resist oxidation, with stable quality, good heating uniformity; the preparation process is simple, efficient, and economical.

In order to achieve the above objectives, in one aspect, the present disclosure provides a heating element, including a substrate and a coating covering an outer surface of the substrate; wherein the substrate comprises a hard phase and a continuous phase; the hard phase comprises a single-phase ceramic or a multi-phase ceramic, the continuous phase comprises a single metal or alloy; the coating is configured to prevent the heating element from oxidizing.

In a specific embodiment, the single metal is chromium or aluminum.

In a specific embodiment, the alloy is an alloy containing chromium and/or aluminum.

In a specific embodiment, a total mass fraction of chromium and/or aluminum in the alloy is 10%-50%.

In a specific embodiment, the coating is a composite coating containing chromium and/or aluminum.

In a specific embodiment, the composite coating is a composite nitride layer containing chromium and/or aluminum.

In a specific embodiment, a total atomic fraction of chromium and/or aluminum in the composite nitride layer is 50%-100%.

In a specific embodiment, the single-phase ceramic comprises one of carbide ceramics, nitride ceramics, boride ceramics, and oxide ceramics.

In a specific embodiment, the single-phase ceramic comprises a single-phase solid solution ceramic formed by multiple substances of carbides, nitrides, borides and oxides.

In a specific embodiment, the multi-phase ceramic comprises a plurality of single-phase ceramics.

In a specific embodiment, the coating has a thickness of 0.5 to 1.5 microns.

In a specific embodiment, the heating element has a resistivity of 0.001 to 0.05 ohm·cm.

In another aspect, the present disclosure provides a method for preparing the heating element above-mentioned, comprising the following steps:
(1) obtaining single-phase or multi-phase ceramic powder, and single metal or alloy powder;
(2) obtaining a powder slurry by ball milling the single-phase or multi-phase ceramic powder, the single metal or alloy powder and additive powder;
(3) obtaining granulated powder by drying the powder slurry;
(4) obtaining the substrate by compression molding and sintering the granulated powder;
(5) obtaining the heating element by coating a surface the substrate.

In a specific embodiment, the heating element is ground and polished on a grinder to improve surface quality of the heating element.

In a specific embodiment, when obtaining the alloy powder, multiple metal elemental powders including chromium and/or aluminum are added into a first ball milling tank according to a certain mass ratio, and after sealing, argon gas is blown in, and then mechanical alloying is performed in the first ball milling tank;
wherein, a ball-to-material ratio of the first ball milling tank is 15:1-25:1, a rotating speed is 300-500 revolutions per minute, and a ball milling time is 48-96 hours.

In a specific embodiment, after the mechanical alloying is completed, stearic acid is added to the first ball milling tank to continue ball milling, and the ball milling time is 0.5 to 4 hours.

In a specific embodiment, a total mass fraction of the chromium and/or aluminum elemental powder is 10%-50%.

In a specific embodiment, the single-phase or multi-phase ceramic powder, the single metal or alloy powder, and the additive powder are added to a second ball milling tank, and ball milling in the second ball milling tank is performed after anhydrous ethanol added;
wherein, a ball-to-material ratio in the second ball milling tank is 5:1-10:1, a rotating speed is 120-350 revolutions per minute, and a ball milling time is 24-96 hours.

In a specific embodiment, a mass fraction of each component in a material of the second ball milling tank is respectively: 42.00%-68.00% of the single-phase or multi-phase ceramic powder, 12.00%-30.00% of the single metal or alloy powder, and 16.5%-46% of the additive powder.

In a specific embodiment, the powder slurry is vacuum dried at a temperature of 75-90 °C.

In a specific embodiment, the compression molding has a compression pressure of 200-400 MPa, and a pressure preservation time is 0.5-2 minutes.

In a specific embodiment, a molded blank after compression molded is sintered at a vacuum degree greater than 1^{∗}10⁻¹ Pa, a sintering temperature is 1220 to 1450 °C, and a temperature preservation time is 15 - 60 minutes.

In a specific embodiment, the substrate is surface-coated on a multi-target magnetron sputtering apparatus;
wherein, a target material of the multi-target magnetron sputtering apparatus is an alloy containing chromium and/or aluminum, a vacuum degree is greater than 3^{∗}10⁻³ Pa, the target material is controlled by a DC cathode, a sputtering power is 80-120 Watts, a sputtering time is 1 to 2 hours, a sputtering temperature is 280-320 °C, and a sputtering coating adopts a mixed gas of argon and nitrogen.

In a specific embodiment, a total atomic fraction of chromium and/or aluminum in the target material is 50%-100%.

In a specific embodiment, the additive powder comprises tungsten carbide powder, molybdenum powder and graphite powder.

In yet another aspect, the present disclosure provides a use of the heating element above-mentioned and the method for preparing the heating element above-mentioned in a heater for a novel tobacco product.

The present disclosure has the following advantages due to the above technical solutions:
1. The heating element of the present disclosure includes a substrate and a coating for preventing oxidation of the substrate. The hard phase of the substrate includes single-phase or multi-phase ceramics. The continuous phase includes a single metal or alloy, has good oxidation resistance, stable quality, and good heating uniformity, such that the heating requirements of new tobacco products can be met.
2. The hard phase of the present disclosure includes single-phase or multi-phase ceramics, it has high strength, good corrosion resistance, wear resistance and thermal stability.
3. The continuous phase of the present disclosure includes a single metal or alloy, and has good ductility and good workability.
4. The present disclosure is provided with a composite nitride layer, such that the oxidation resistance and stability of the coating can be improved.
5. The continuous phase of the present disclosure is a single metal chromium or aluminum, or an alloy containing chromium and/or aluminum, and the coating is a composite coating containing chromium or aluminum, such that the bonding strength of the coating and the substrate can be improved.
6. The method for preparing the heating element of the present disclosure is simple, efficient, and economical.
7. The present disclosure can obtain an alloy with uniform quality through mechanical alloying, and improve the mechanical, physical and chemical properties of the alloy.
8. The present disclosure uses a multi-target magnetron sputtering apparatus for surface coating, such that the uniformity of the coating can be improved.
9. The additive powder of the present disclosure includes tungsten carbide powder, molybdenum powder and graphite powder, playing the role of grain refinement, strengthening and toughening.
10. The present disclosure has simple structure, convenient use and broad market prospects.

Other features and advantages of the present disclosure will be described in the following description, and part of them becomes obvious from the description, or understood by implementing the present disclosure. The objectives and other advantages of the present disclosure can be realized and obtained through the structures specifically pointed out in the specification and claims.

### DESCRIPTION OF EMBODIMENTS

The following will describe the implementation of the present disclosure in detail with reference to the embodiments, so as to fully understand and implement the process of how the present disclosure applies technical means to solve technical problems and achieve technical effects. It should be noted that, as long as there is no conflict, the various embodiments of the present disclosure and the various embodiments and the various features can be combined with one another, and the technical solutions formed are all within the protection scope of the present disclosure.

In one aspect, the heating element provided by the present disclosure may include a substrate and a coating covering the outer surface of the substrate. Among them, the substrate may include a hard phase and a continuous phase, and the hard phase may include single-phase or multi-phase ceramics, with high strength, good corrosion resistance, wear resistance and thermal stability. The continuous phase may include a single metal or alloy with good ductility and workability. The coating may be used to prevent oxidation of the heating element. The heating element of the present disclosure has good oxidation resistance, stable product quality and good heating uniformity, and can meet the heating requirements of new tobacco products.

In a preferred embodiment, the single metal is chromium.

In another preferred embodiment, the single metal is aluminum.

In a specific embodiment, the alloy is an alloy containing chromium and/or aluminum, such that thermal conductivity, wear resistance, corrosion resistance and oxidation resistance can be improved, making the substrate have good mechanical properties, physical properties and chemical properties.

In a specific embodiment, the total mass fraction of chromium and/or aluminum in the alloy is 10% to 50%, such that thermal conductivity, corrosion resistance and oxidation resistance can be further improved.

In a specific embodiment, the coating is a composite coating containing chromium and/or aluminum, with good oxidation resistance and stability. At the same time, since the continuous phase is a single metal chromium or aluminum, or an alloy containing chromium and/or aluminum, and the coating is a composite coating containing chromium and/or aluminum, the bonding strength of the coating and the substrate can be improved.

In a preferred embodiment, the composite coating is a composite nitride layer containing chromium and/or aluminum, such that oxidation resistance and stability can be improved.

In a specific embodiment, the total atomic fraction of chromium and/or aluminum in the composite nitride layer is 50% to 100%.

In a specific embodiment, the single-phase ceramic includes one of carbide ceramics, nitride ceramics, boride ceramics, and oxide ceramics.

In a specific embodiment, single-phase ceramics include single-phase solid solution ceramics formed by a variety of substances among carbides, nitrides, borides, and oxides.

In a specific embodiment, the multi-phase ceramic includes a plurality of single-phase ceramics.

In a specific embodiment, the thickness of the coating is 0.5 to 1.5 microns.

In a specific embodiment, the resistivity of the heating element is 0.001 to 0.05 ohm- cm.

In the other aspect, on the basis of the above heating element, the method for preparing the heating element provided by the present disclosure includes the following steps:
(1) obtaining single-phase or multi-phase ceramic powder, and single metal or alloy powder;
(2) obtaining a powder slurry by ball milling the single-phase or multi-phase ceramic powder, the single metal or alloy powder and additive powder;
(3) obtaining granulated powder by drying the powder slurry;
(4) obtaining the substrate by compression molding and sintering the granulated powder;
(5) obtaining the heating element by coating a surface the substrate.

In a specific embodiment, grinding and polishing the heating element on a grinder can improve the surface quality of the heating element.

In a specific embodiment, when the alloy powder is obtained, a variety of metal elemental powders including at least chromium or aluminum are added to the first ball milling tank according to a certain mass ratio, and argon gas is introduced after sealing. Mechanical alloying is carried out in a ball milling tank. Mechanical alloying is a process in which high-energy grinders or ball mills can be used to achieve solid-state alloying. The process is simple, efficient, and economical. At the same time, mechanical alloying can make the quality of the alloy uniform and improve the mechanical, physical and chemical properties of the alloy. Among them, the ball-to-material ratio of the first ball milling tank is 15:1-25:1, the rotating speed is 300-500 revolutions per minute, and the ball milling time is 48-96 hours, such that the quality of the ball mill can be improved.

In a specific embodiment, after the mechanical alloying is completed, stearic acid is added to the first ball milling tank to continue ball milling, and the ball milling time is 0.5 to 4 hours, such that grains can be refined, and grain fluidity can be improved. The dispersion of powder particles is good.

In a specific embodiment, the total mass fraction of chromium and/or aluminum elemental powder is 10% to 50%, such that thermal conductivity, corrosion resistance and oxidation resistance can be further improved.

In a specific embodiment, single-phase or multi-phase ceramic powder, single metal or alloy powder, and additive powder are added to the second ball milling tank, and after adding absolute ethanol, ball milling is performed in the second ball milling tank, The mixing effect is good and the ball milling quality can be improved. Among them, the ball-to-material ratio in the second ball milling tank is 5:1-10:1, the rotating speed is 120-350 revolutions per minute, and the ball milling time is 24 to 96 hours, such that the ball milling quality can be improved.

In a specific embodiment, the mass fractions of the components in the material of the second ball mill are respectively: 42.00%-68.00% of single-phase or multi-phase ceramic powder, 12.00%-30.00 % of single metal or alloy powder, 16.5%-46% of the additive powder.

In a specific embodiment, the powder slurry is vacuum dried at a temperature of 75 to 90 °C, such that the drying speed can be increase and a good drying effect can be achieved.

In a specific embodiment, the compression pressure of the compression molding is 200-400 MPa, and the pressure preservation time is 0.5-2 minutes.

In a specific embodiment, the molded blank is sintered at a vacuum degree greater than 1^{∗}10⁻¹ Pa, the sintering temperature is 1220 to 1450 °C, and temperature preservation time is 15 to 60 minutes, such that the compactness of the substrate can be improved, the comprehensive mechanical properties of the substrate can be improved.

In a specific embodiment, after the substrate is cleaned and dried, the surface coating is performed on the multi-target magnetron sputtering apparatus, such that the uniformity of the coating can be improved. Wherein, the target material of the multi-target magnetron sputtering apparatus is an alloy containing chromium and/or aluminum, the vacuum degree is greater than 3^{∗}10⁻³ Pa, the target material is controlled by a DC cathode, the sputtering power is 80-120 watts, the sputtering time is 1 to 2 hours, and the sputtering temperature is 280-320 °C, the sputtering coating adopts a mixed gas of argon and nitrogen, such that oxidation can be prevented and the oxidation resistance of the coating can be improved.

In a specific embodiment, the purity of the mixed gas is not less than 99.999%, such that the oxidation resistance of the coating can be further improved.

In a specific embodiment, the gas flow ratio of argon to nitrogen is 1:1, which has good stability.

In a preferred embodiment, the total atomic fraction of chromium and/or aluminum in the target material is 50% to 100%.

In a specific embodiment, the coating is a composite coating containing chromium and/or aluminum, with good oxidation resistance and stability, such that the bonding strength of the coating can be improved.

In a preferred embodiment, the composite coating is a composite nitride layer containing chromium and/or aluminum, such that oxidation resistance and stability can be improved.

In a specific embodiment, the total atomic fraction of chromium and/or aluminum in the composite nitride layer is 50% to 100%, such that the oxidation resistance and stability of the coating can be further improved.

In a specific embodiment, the additive powder includes tungsten carbide powder, molybdenum powder and graphite powder, playing a role in strengthening, toughening and refining crystal grains.

The method for preparing the heating element of the present disclosure is simple, efficient, economical. The prepared heating element has good oxidation resistance, the product quality is more stable, and the heat generation is more uniform.

In yet another aspect, the present disclosure provides a use of the above-mentioned heating element according to the present disclosure and the above-mentioned method for preparing the heating element according to the present disclosure in the preparation of a new type of heating element for tobacco products.

In a specific embodiment, the heating element is used to heat low-temperature cigarettes.

A number of specific embodiments are listed below.

### Embodiment One

In this embodiment, the method for preparing the heating element may include the following steps:
(1) adding Ni (nickel) and Cr (chromium) elemental powders to the first high-energy ball milling tank at a mass fraction of 1:1, leading Ar (argon) gas into the first high-energy ball milling tank for mechanical alloying. Among them, the ball-to-material ratio of the first high-energy ball milling tank is 15:1, the rotating speed is 300 rpm (revolutions per minute), and the milling time is 48h (hours); adding 2% SA (stearic acid) to the first high-energy ball milling tank after completion, and continuing ball milling for 0.5 hours, taking out NiCr (nickel chromium) alloy powder after completion.
(2) adding Ti (C, N) (titanium carbonitride) solid solution powder, nickel-chromium alloy powder, WC (tungsten carbide) powder, Mo (molybdenum) powder and C (graphite) powder into the second high-energy ball milling tank, adding anhydrous ethanol and then performing a ball milling. Among them, the ball-to-material ratio of the second high-energy ball milling tank is 5:1, the rotating speed is 120 revolutions per minute, and the ball milling time is 24 hours.
(3) vacuum drying the prepared powder slurry at a temperature of 80° C to obtain granulated powder.
(4) compression molding the granulated powder; the compression pressure is 400MPa (megapascals), the pressure preservation time is lmin; and sintering the molded blank after compression molded is under a vacuum degree of more than 1^{∗}10⁻¹Pa (Pascals); the sintering temperature is 1420 °C, and the temperature preservation time is 60 minutes.
(5) performing a surface-coating on a multi-target magnetron sputtering apparatus after the sintered sample cleaned and dried. The target material is a CrAl alloy, in which the atomic ratio of Al (aluminum) and Cr (chromium) is 1:1; the vacuum degree is 2.5^{∗}10⁻³ Pa, the sputtering power is 80 watts, the sputtering time is 1.5 hours, and the sputtering temperature is 280 °C; the sputtering coating uses a mixture of argon and N₂ (nitrogen) with a purity of 99.999%, and the gas flow ratio of argon and nitrogen is 1:1. The test results show that, as shown in Table 1, it can meet the electrical and structural characteristics of the heating element in the heater for low-temperature cigarettes.

Further, the coated sample is ground and polished on a grinder.

Further, the mass fraction of titanium carbonitride solid solution powder is 42%, the mass fraction of nickel-chromium alloy powder is 30%, the mass fraction of tungsten carbide powder is 13%, the mass fraction of molybdenum powder is 14%, and the mass fraction of graphite powder is 1%.

### Embodiment Two

In this embodiment, the method for preparing the heating element may include the following steps:
(1) adding Ni (nickel) and Al (aluminum) elemental powders to the first high-energy ball milling tank at a mass fraction of 1:2, leading Ar (argon) gas into the first high-energy ball milling tank for mechanical alloying. Among them, the ball-to-material ratio of the first high-energy ball milling tank is 20:1, the rotating speed is 350 rpm, and the milling time is 64h (hours); adding 2% SA (stearic acid) to the first high-energy ball milling tank after completion, and continuing ball milling for 2 hours, taking out NiAl (nickel aluminum) alloy powder after completion.
(2) adding titanium carbide and boron carbide powder, nickel aluminum alloy powder, tungsten carbide powder, molybdenum powder and graphite powder into the second high-energy ball milling tank, adding anhydrous ethanol and then performing a ball milling. Among them, the ball-to-material ratio of the second high-energy ball milling tank is 7:1, the rotating speed is 220 revolutions per minute, and the ball milling time is 36 hours.
(3) vacuum drying the prepared powder slurry at a temperature of 75° C to obtain granulated powder.
(4) compression molding the granulated powder; the compression pressure is 300MPa, the pressure preservation time is lmin; and sintering the molded blank after compression molded is under a vacuum degree of more than 1^{∗}10⁻¹Pa; the sintering temperature is 1250 °C, and the temperature preservation time is 45 minutes.
(5) performing a surface-coating on a multi-target magnetron sputtering apparatus after the sintered sample cleaned and dried. The target material is a TiAl (titanium aluminum) alloy, in which the atomic ratio of Ti (titanium) and Al (aluminum) is 5:1; the vacuum degree is 3^{∗}10⁻³ Pa, the sputtering power is 110 watts, the sputtering time is 2 hours, and the sputtering temperature is 300 °C; the sputtering coating uses a mixture of argon and N₂ (nitrogen) with a purity of 99.999%, and the gas flow ratio of argon and nitrogen is 1:1. The test results show that, as shown in Table 1, it can meet the electrical and structural characteristics of the heating element in the heater for low-temperature cigarettes.

Further, the coated sample may be ground and polished on a grinder.

Further, the mass fraction of solid solution powder formed by titanium carbide and boron carbide is 45%, the mass fraction of nickel aluminum alloy powder is 27%, the mass fraction of tungsten carbide powder is 12%, the mass fraction of molybdenum powder is 15%, and the mass fraction of graphite powder is 1%.

### Embodiment Three

In this embodiment, the method for preparing the heating element may include the following steps:
(1) adding Ni and Cr elemental powders to the first high-energy ball milling tank at a mass fraction of 3:1, leading Ar gas into the first high-energy ball milling tank for mechanical alloying. Among them, the ball-to-material ratio of the first high-energy ball milling tank is 25:1, the rotating speed is 320 rpm, and the milling time is 72h (hours); adding 2% SA (stearic acid) to the first high-energy ball milling tank after completion, and continuing ball milling for 2 hours, taking out NiCr (nickel chromium) alloy powder after completion.
(2) adding titanium carbonitride powder, nickel-chromium alloy powder, WC (tungsten carbide) powder, Mo (molybdenum) powder and graphite powder into the second high-energy ball milling tank, adding anhydrous ethanol and then performing a ball milling. Among them, the ball-to-material ratio of the second high-energy ball milling tank is 7:1, the rotating speed is 350 rpm, and the ball milling time is 48 hours.
(3) vacuum drying the prepared powder slurry at a temperature of 90° C to obtain granulated powder.
(4) compression molding the granulated powder; the compression pressure is 300MPa, the pressure preservation time is 2 min; and sintering the molded blank after compression molded is under a vacuum degree of more than 1^{∗}10⁻¹Pa; the sintering temperature is 1450 °C, and the temperature preservation time is 60 minutes.
(5) performing a surface-coating on a multi-target magnetron sputtering apparatus after the sintered sample cleaned and dried. The target material is a nickel-chromium alloy, in which the atomic ratio of Cr and Ni is 3:1; the vacuum degree is 2.5^{∗}10⁻³ Pa, the sputtering power is 80 watts, the sputtering time is 1 hour, and the sputtering temperature is 320 °C; the sputtering coating uses a mixture of argon and N₂ (nitrogen) with a purity of 99.999%, and the gas flow ratio of argon and nitrogen is 1:1. The test results show that, as shown in Table 1, it can meet the electrical and structural characteristics of the heating element in the heater for low-temperature cigarettes.

Further, the coated sample is ground and polished on a grinder.

Further, the mass fraction of titanium carbide solid solution powder is 68%, the mass fraction of nickel-chromium alloy powder is 12%, the mass fraction of tungsten carbide powder is 13%, the mass fraction of molybdenum powder is 6%, and the mass fraction of graphite powder is 1%.

### Embodiment Four

In this embodiment, the method for preparing the heating element may include the following steps:
(1) adding Fe, Cr and Ni elemental powders to the first high-energy ball milling tank at a mass fraction of 1:4:1, leading Ar (argon) gas into the first high-energy ball milling tank for mechanical alloying. Among them, the ball-to-material ratio of the first high-energy ball milling tank is 20:1, the rotating speed is 350 rpm, and the milling time is 96h; adding 2% SA (stearic acid) to the first high-energy ball milling tank after completion, and continuing ball milling for 4 hours, taking out FeCrNi alloy powder after completion.
(2) adding TiC and Al₂O₃ powder, iron-chromium-nickel alloy powder, tungsten carbide powder, molybdenum powder and graphite powder into the second high-energy ball milling tank, adding anhydrous ethanol and then performing a ball milling. Among them, the ball-to-material ratio of the second high-energy ball milling tank is 5:1, the rotating speed is 230 revolutions per minute, and the ball milling time is 24 hours.
(3) vacuum drying the prepared powder slurry at a temperature of 80° C to obtain granulated powder.
(4) compression molding the granulated powder; the compression pressure is 300MPa, the pressure preservation time is lmin; and sintering the molded blank after compression molded is under a vacuum degree of more than 1^{∗}10⁻¹Pa; the sintering temperature is 1350 °C, and the temperature preservation time is 60 minutes.
(5) performing a surface-coating on a multi-target magnetron sputtering apparatus after the sintered sample cleaned and dried. The target material is a CrAl alloy, in which the atomic ratio of Al and Cr is 1:1; the vacuum degree is 2.5^{∗}10⁻³ Pa, the sputtering power is 120 watts, the sputtering time is 1 hour, and the sputtering temperature is 320 °C; the sputtering coating uses a mixture of argon and N₂ (nitrogen) with a purity of 99.999%, and the gas flow ratio of argon and nitrogen is 1:1. The test results show that, as shown in Table 1, it can meet the electrical and structural characteristics of the heating element in the heater for low-temperature cigarettes.

Further, the coated sample may be ground and polished on a grinder.

Further, the mass fraction of titanium carbide and alumina solid solution powder is 51%, the mass fraction of nickel-chromium alloy powder is 20%, the mass fraction of tungsten carbide powder is 14%, the mass fraction of molybdenum powder is 14%, and the mass fraction of graphite powder is 1%.

### Embodiment Five

In this embodiment, the method for preparing the heating element may include the following steps:
(1) adding Ni and Al elemental powders to the first high-energy ball milling tank at a mass fraction of 1:4, leading Ar (argon) gas into the first high-energy ball milling tank for mechanical alloying. Among them, the ball-to-material ratio of the first high-energy ball milling tank is 15:1, the rotating speed is 300 rpm, and the milling time is 48h; adding 2% SA (stearic acid) to the first high-energy ball milling tank after completion, and continuing ball milling for 2 hours, taking out NiAl alloy powder after completion.
(2) adding SiC powder, nickel aluminum alloy powder, tungsten carbide powder, molybdenum powder and graphite powder into the second high-energy ball milling tank, adding anhydrous ethanol and then performing a ball milling. Among them, the ball-to-material ratio of the second high-energy ball milling tank is 7:1, the rotating speed is 320 revolutions per minute, and the ball milling time is 24 hours.
(3) vacuum drying the prepared powder slurry at a temperature of 80° C to obtain granulated powder.
(4) compression molding the granulated powder; the compression pressure is 400MPa, the pressure preservation time is lmin; and sintering the molded blank after compression molded is under a vacuum degree of more than 1^{∗}10⁻¹ Pa; the sintering temperature is 1410 °C, and the temperature preservation time is 60 minutes.
(5) performing a surface-coating on a multi-target magnetron sputtering apparatus after the sintered sample cleaned and dried. The target material is a TiAl alloy, in which the atomic ratio of Al and Ti is 2:1; the vacuum degree is 2.5^{∗}10⁻³ Pa, the sputtering power is 80 watts, the sputtering time is 2 hours, and the sputtering temperature is 320 °C; the sputtering coating uses a mixture of argon and N₂ (nitrogen) with a purity of 99.999%, and the gas flow ratio of argon and nitrogen is 1:1. The test results show that, as shown in Table 1, it can meet the electrical and structural characteristics of the heating element in the heater for low-temperature cigarettes.

Further, the coated sample may be ground and polished on a grinder.

Further, the mass fraction of tungsten carbide solid solution powder is 52%, the mass fraction of nickel aluminum alloy powder is 30%, the mass fraction of tungsten carbide powder is 8%, the mass fraction of molybdenum powder is 9%, and the mass fraction of graphite powder is 1%.

**Table 1: Properties of heating element materials in each embodiment**

| Emb. No. | Hardness (HRA/Rockwell hardness) | Anti-bend strength (MPa) | Fracture toughness K_{1c} (MPa^{∗}m^{1/2}) | Resistivity (Ohm^{∗}cm) | Weight gain rate (400°C^{∗}100h) mg/cm² |
|---|---|---|---|---|---|
| 1 | 91.2 | 1782 | 8.1 | 0.0042 | 0.072 |
| 2 | 92.0 | 1673 | 8.0 | 0.0043 | 0.064 |
| 3 | 92.0 | 1231 | 5.5 | 0.0060 | 0.057 |
| 4 | 91.3 | 1658 | 6.3 | 0.0057 | 0.053 |
| 5 | 91.4 | 1722 | 8.5 | 0.0045 | 0.068 |

Although the disclosed embodiments of the present disclosure are as described above, the content described is only the embodiments used to facilitate the understanding of the present disclosure, and is not intended to limit the present disclosure. Any person skilled in the technical field of the present disclosure can make any modifications and changes in the form and details of the implementation without departing from the spirit and scope of the present disclosure. However, the patent protection scope of the present disclosure is still subject to the scope defined by the appended claims.

## Claims

1. A heating element, comprising a substrate and a coating covering an outer surface of the substrate; wherein the substrate comprises a hard phase and a continuous phase; the hard phase comprises a single-phase ceramic or a multi-phase ceramic, the continuous phase comprises a single metal or alloy; the coating is configured to prevent the heating element from oxidizing.

2. The heating element according to claim 1, wherein the single metal is chromium or aluminum.

3. The heating element according to claim 1, wherein the alloy is an alloy containing chromium and/or aluminum.

4. The heating element according to claim 3, wherein a total mass fraction of chromium and/or aluminum in the alloy is 10%-50%.

5. The heating element according to claim 1, wherein the coating is a composite coating containing chromium and/or aluminum.

6. The heating element according to claim 5, wherein the composite coating is a composite nitride layer containing chromium and/or aluminum.

7. The heating element according to claim 6, wherein a total atomic fraction of chromium and/or aluminum in the composite nitride layer is 50%-100%.

8. The heating element according to claim 1, wherein the single-phase ceramic comprises one of carbide ceramics, nitride ceramics, boride ceramics, and oxide ceramics.

9. The heating element according to claim 1, wherein the single-phase ceramic comprises a single-phase solid solution ceramic formed by multiple substances of carbides, nitrides, borides and oxides.

10. The heating element according to claim 1, wherein the multi-phase ceramic comprises a plurality of single-phase ceramics.

11. The heating element according to claim 1, wherein the coating has a thickness of 0.5 to 1.5 microns.

12. The heating element according to claim 1, wherein the heating element has a resistivity of 0.001 to 0.05 ohm-cm.

13. A method for preparing the heating element according to any one of claims 1-12, comprising the following steps:
(1) obtaining single-phase or multi-phase ceramic powder, and single metal or alloy powder;
(2) obtaining a powder slurry by ball milling the single-phase or multi-phase ceramic powder, the single metal or alloy powder and additive powder;
(3) obtaining granulated powder by drying the powder slurry;
(4) obtaining the substrate by compression molding and sintering the granulated powder;
(5) obtaining the heating element by coating a surface the substrate.

14. The method according to claim 13, wherein the heating element is ground and polished on a grinder to improve surface quality of the heating element.

15. The method according to claim 13, wherein, when obtaining the alloy powder, multiple metal elemental powders including chromium and/or aluminum are added into a first ball milling tank according to a certain mass ratio, and after sealing, argon gas is blown in, and then mechanical alloying is performed in the first ball milling tank;
wherein, a ball-to-material ratio of the first ball milling tank is 15:1-25:1, a rotating speed is 300-500 revolutions per minute, and a ball milling time is 48-96 hours.

16. The method according to claim 15, wherein after the mechanical alloying is completed, stearic acid is added to the first ball milling tank to continue ball milling, and the ball milling time is 0.5 to 4 hours.

17. The method according to claim 15, wherein a total mass fraction of the chromium and/or aluminum elemental powder is 10%-50%.

18. The method according to claim 13, wherein the single-phase or multi-phase ceramic powder, the single metal or alloy powder, and the additive powder are added to a second ball milling tank, and ball milling in the second ball milling tank is performed after anhydrous ethanol added;
wherein, a ball-to-material ratio in the second ball milling tank is 5:1-10:1, a rotating speed is 120-350 revolutions per minute, and a ball milling time is 24-96 hours.

19. The method according to claim 18, wherein a mass fraction of each component in a material of the second ball milling tank is respectively: 42.00%-68.00% of the single-phase or multi-phase ceramic powder, 12.00%-30.00% of the single metal or alloy powder, and 16.5%-46% of the additive powder.

20. The method according to claim 13, wherein the powder slurry is vacuum dried at a temperature of 75-90 °C.

21. The method according to claim 13, wherein the compression molding has a compression pressure of 200-400 MPa, and a pressure preservation time is 0.5-2 minutes.

22. The method according to claim 13, wherein a molded blank after compression molded is sintered at a vacuum degree greater than 1^{∗}10⁻¹ Pa, a sintering temperature is 1220 to 1450 °C, and a temperature preservation time is 15 - 60 minutes.

23. The method according to claim 13, wherein the substrate is surface-coated on a multi-target magnetron sputtering apparatus;
wherein, a target material of the multi-target magnetron sputtering apparatus is an alloy containing chromium and/or aluminum, a vacuum degree is greater than 3^{∗}10⁻³ Pa, the target material is controlled by a DC cathode, a sputtering power is 80-120 Watts, a sputtering time is 1 to 2 hours, a sputtering temperature is 280-320 °C, and a sputtering coating adopts a mixed gas of argon and nitrogen.

24. The method according to claim 23, wherein a total atomic fraction of chromium and/or aluminum in the target material is 50%-100%.

25. The method according to claim 13, wherein the additive powder comprises tungsten carbide powder, molybdenum powder and graphite powder.

26. Use of the heating element according to any one of claims 1-12 and the method for preparing the heating element according to any one of claims 13-25 in a heater for a novel tobacco product.
